# EUROPEAN PATENT APPLICATION

(11) **EP 4 350 791 A1**
(43) Date of publication of application: **10.04.2024**
(21) Application number: 22810844.5
(22) Date of filing: 08.02.2022
(51) Int. Cl.: H01L 51/44, C09K 11/06, H01L 51/46

(54) **COMPOUND AND ELECTRONIC DEVICE AND LIGHT-EMITTING ELEMENT USING SAME**

(30) Priority: 26.05.2021 JP 2021088718
(71) Applicant: Panasonic Intellectual Property Management Co., Ltd., Kadoma-shi, Osaka 571-0057 (JP)
(72) Inventor: SEKIMOTO, Takeyuki, Kadoma-shi, Osaka, 571-0057 (JP); YOKOYAMA ,Tomoyasu, Kadoma-shi, Osaka, 571-0057 (JP)
(74) Representative: Grünecker Patent- und Rechtsanwälte PartG mbB
(86) International application number: PCT/JP2022/004782
(87) International publication number: WO 2022/249559

(57) **Abstract**

A compound of the present disclosure consists of A, Ag, and X. A is a monovalent cation and contains an organic cation. X is at least one selected from the group consisting of a halide ion and a thiocyanate ion. A photoelectric conversion device 100 of the present disclosure includes a first electrode 2, a photoelectric conversion layer 4, and a second electrode 6 arranged in this order. The photoelectric conversion device 100 of the present disclosure contains the aforementioned compound of the present disclosure.

## Description

### Technical Field

The present disclosure relates to a compound, and an electronic device and a light-emitting device using the same.

### Background Art

In recent years, research and development on perovskite solar batteries that use organic-inorganic hybrid perovskite compounds in photoelectric conversion layers have seen much progress. In particular, perovskite solar batteries that use lead-containing perovskite compounds are considered to be applicable to various usages since these batteries exhibit high photoelectric conversion efficiency and can be formed by a coating process.

In NPL 1, the energy levels of various three-dimensional perovskite compounds are studied. This literature indicates that, when lead is contained, methylammonium lead chloride has the largest bandgap (3.04 eV), and when lead is not contained, formamidinium tin chloride has the largest bandgap (3.55 eV).

NPL 2 indicates that a two-dimensional perovskite compound (C₆H₅-C₂H₄-NH₃)₂PbCl₄, which has a layered structure and is formed by a coating method, has an exciton absorption peak at about 3.64 eV in an absorption spectrum.

NPL 3 reports that crystals of a two-dimensional perovskite compound (C₄H₉NH₃)₂PbCl₄ prepared by a liquid phase growth method exhibit a highly efficient photoluminescence, in other words, exhibit band edge emission, at about 3.65 eV. In other words, NPL 3 indicates that crystals of a two-dimensional perovskite compound (C₄H₉NH₃)₂PbCl₄ prepared by a liquid phase growth method has a bandgap of 3.65 eV.

### Citation List

### Non Patent Literature

NPL 1: S. Tao, et al., Nature Communications, June 2019, Vol. 10, p. 2560.
NPL 2: G. Lanty, et al., The Journal of Physical Chemistry Letters, October 2014, Vol. 5, pp. 3958-3963.
NPL 3: L. Dou, et al., Science, September 2015, Vol. 349, pp. 1518-1521.

### Summary of Invention

### Technical Problem

An object of the present disclosure is to provide a compound having a bandgap suitable for electronic devices.

### Solution to Problem

A compound of the present disclosure consists of:
A, Ag, and X,
where A is a monovalent cation and comprises an organic cation, and
X is at least one selected from the group consisting of a halide ion and a thiocyanate ion.

### Advantageous Effects of Invention

The present disclosure provides a compound having a bandgap suitable for electronic devices.

### Brief Description of Drawings

[Fig. 1] Fig. 1 is a cross-sectional view illustrating a schematic structure of a photoelectric conversion device 100 according to a second embodiment.
[Fig. 2] Fig. 2 is a cross-sectional view illustrating a schematic structure of a photoelectric conversion device 200 according to the second embodiment.
[Fig. 3] Fig. 3 is a cross-sectional view illustrating a schematic structure of a photoelectric conversion device 300 according to the second embodiment.
[Fig. 4] Fig. 4 is a cross-sectional view illustrating a schematic structure of a photoelectric conversion device 400 according to the second embodiment.
[Fig. 5] Fig. 5 is a graph illustrating X-ray diffraction patterns of compounds of Examples 1 to 4.
[Fig. 6] Fig. 6 is a graph illustrating X-ray diffraction patterns of compounds of Examples 5 to 8.
[Fig. 7] Fig. 7 is a graph illustrating X-ray diffraction patterns of compounds of Examples 9 and 10.
[Fig. 8] Fig. 8 is a graph illustrating X-ray diffraction patterns of compounds of Examples 11 to 15.
[Fig. 9] Fig. 9 is a graph illustrating Tauc plots of compounds of Examples 1 to 4.
[Fig. 10] Fig. 10 is a graph illustrating Tauc plots of compounds of Examples 5 to 8.
[Fig. 11] Fig. 11 is a graph illustrating Tauc plots of compounds of Examples 9 and 10.
[Fig. 12] Fig. 12 is a graph illustrating Tauc plots of compounds of Examples 11 to 15.
[Fig. 13] Fig. 13 is a graph illustrating photoelectron yield spectra of compounds of Examples 1 to 4.
[Fig. 14] Fig. 14 is a graph illustrating photoelectron yield spectra of compounds of Examples 5 to 8.
[Fig. 15] Fig. 15 is a graph illustrating photoelectron yield spectra of compounds of Examples 9 and 10.
[Fig. 16] Fig. 16 is a graph illustrating photoelectron yield spectra of compounds of Examples 11 to 15.

### Description of Embodiments

### <Underlying Knowledge Forming Basis of the Present Disclosure>

There have been reports of materials having various wide bandgaps as the material for photoelectric conversion layers or emission layers of electronic devices in the ultraviolet region.

NPL 1 discloses three-dimensional perovskite compounds that have wide bandgaps ranging from 3.04 eV to 3.64 eV. However, the energy levels of the valence band upper edges of these materials are as deep as -6.9 eV or less, and this poses a problem in that, when these materials are used in photoelectric conversion layers, hole extraction is difficult.

There have also been reports of various two-dimensional perovskite compounds having wide bandgaps. For example, a (C₆H₅-C₂H₄-NH₃)₂PbCl₄ film disclosed in NPL 2 has an exciton absorption peak at about 3.64 eV in an absorption spectrum. The crystals of (C₄H₉NH₃)₂PbCl₄ disclosed in NPL 3 exhibit a highly efficient photoluminescence at about 3.65 eV. However, the problem has been that these compounds contain highly toxic lead.

These known compounds have been extensively studied, and, as a result, the present inventors have found that a lead-free organic-inorganic hybrid silver halide compound has a bandgap suitable for photoelectric conversion devices or light-emitting devices and has a valence band upper edge with a shallow energy level. Furthermore, this silver halide compound can be easily formed into thin films by a coating method.

### (First embodiment)

A compound according to a first embodiment consists of A, Ag, and X, where A is a monovalent cation and comprises an organic cation, and X is at least one selected from the group consisting of a halide ion and a thiocyanate ion.

The compound according to the first embodiment has a bandgap suitable for electronic devices. The compound according to the first embodiment has a large bandgap.

The halide ion may be at least one selected from the group consisting of a fluoride ion, a chloride ion, a bromide ion, and an iodide ion.

The compound according to the first embodiment may have a bandgap greater than or equal to 3.10 eV and less than or equal to 5.10 eV. The compound according to the first embodiment may have a bandgap greater than or equal to 3.38 eV and less than or equal to 4.93 eV.

The compound according to the first embodiment has a valence band upper edge with a shallow energy level. The compound according to the first embodiment may have a valence band upper edge having an energy level greater than or equal to -6.20 eV and less than or equal to -5.00 eV with respect to the vacuum level. The compound according to the first embodiment may have a valence band upper edge having an energy level greater than or equal to -6.00 eV and less than or equal to -5.19 eV with respect to the vacuum level.

The compound according to the first embodiment can be used in an electronic device or a light-emitting device that operate in the ultraviolet region, for example. The electronic device is, for example, a photoelectric conversion device. Examples of the photoelectric conversion device include solar batteries, ultraviolet sensors, and light-emitting diodes. Since the compound of the first embodiment is transparent, the compound may be used in see-through solar batteries.

Furthermore, the compound according to the first embodiment emits light by absorbing ultraviolet light, for example. The compound according to the first embodiment emits light by absorbing ultraviolet light, for example.

The compound according to the first embodiment can be used in, for example, a light-emitting device due to its property to emit light upon ultraviolet absorption. The light-emitting device can be used as a phosphor of an LED lamp, a plasma display, etc.

In the compound according to the first embodiment, the ionic radius of the monovalent organic cation A (in other words, an effective ionic radius) may be greater than or equal to 216 pm and less than or equal to 450 pm. As a result, the compound has a stable crystal structure. Thus, phase separation can be inhibited. Hereinafter, the "ionic radius" refers to the "effective ionic radius" in this description.

In the compound according to the first embodiment, the monovalent organic cation A may be at least one selected from the group consisting of a hydroxylamine cation, a methylammonium cation, a hydrazinium cation, an azetidinium cation, a formamidinium cation, an imidazolium cation, a dimethylammonium cation, an ethylammonium cation, a guanidinium cation, a trimethylammonium cation, a tetramethylammonium cation, a thiazolium cation, a piperazinium cation, a tropylium cation, a dabconium cation, a butylammonium cation, a benzylammonium cation, a phenethylammonium cation, and a tetrapropylammonium cation. As a result, the compound has a stable crystal structure. Thus, phase separation is inhibited.

These organic cations, for example, when used with lead-containing perovskite compounds, can occupy the gaps of the Pb-X lattice of the perovskite compound. In addition, since the ionic radius of Ag⁺ (115 pm) is close to the ionic radius of Pb²⁺ (119 pm), the aforementioned organic cation can also occupy the gaps of the Ag-X lattice. The lower limit and the upper limit of the ionic radius of organic cation that can occupy the gaps of the Ag-X lattice are, respectively, 216 pm, which is the ionic radius of hydroxylamine or methylammonium, and 450 pm, which is the ionic radius of tetrapropylammonium. The ionic radii of organic cations disclosed in the present description are generally known values and can also be calculated from the ionic radii of atoms, etc. (Gregor Kieslich et al., Chemical Science, 2014, Vol. 5, pp. 4712-4715).

In the compound of the first embodiment, the monovalent organic cation A may be at least one selected from the group consisting of a methylammonium cation (hereinafter may also be referred to as "MA" or "MA⁺"), a formamidinium cation (hereinafter referred to as "FA" or "FA⁺"), an ethylammonium cation (hereinafter referred to as "EA" or "EA⁺"), and a guanidinium cation (hereinafter referred to as "GA" or "GA⁺"). In this manner, the compound according to the first embodiment can have a larger bandgap, a valence band upper edge with a shallow energy level, and a stable crystal structure.

In the compound according to the first embodiment, X may contain at least one selected from the group consisting of a chloride ion, a bromide ion, and an iodide ion. X may contain an iodide ion. X may be an iodide ion. In this manner, the compound according to the first embodiment has a large bandgap, a valence band upper edge with a shallow energy level, and a stable crystal structure.

The compound according to the first embodiment may have a composition represented by AAgX₂, AAg₂X₃, A₂AgX₃, AAg₃X₄, or A₃AgX₄.

The compound according to the first embodiment may have a composition represented by AAgX₂, AAg₂X₃, or A₂AgX₃. These compounds have a larger bandgap, a valence band upper edge with a shallow energy level, and a stable crystal structure.

Theoretical calculation of the formation energy was carried out in advance in synthesizing the compound of the first embodiment where A was FA and X was an iodide ion. The results found that the compounds represented by FAAGI₂, FAAg₂I₃, FAAg₃I₄, and FA₂AGI₃ had a stable structure, and the formation energy thereof was as low as less than 34.2 MeV/atom. Thus, these compounds are easy to synthesize. Specifically, when the formation energy of a compound Z is represented by E_{form}(Z) and the total energy of the first-principles calculation is represented by Eₜₒₜ(Z), the formation energy E_{form}(FAₓAg₁₋ₓI₂) of FAₓAg₁₋ₓI₂ is calculated by E_{form}(FAₓAg₁₋ₓI₂) = Eₜₒₜ(FAₓAg₁₋ₓI₂) - (1 - x)Eₜₒₜ(AgI) - xEₜₒₜ(FAI). Here, x satisfies 0 < x < 1 and FA is calculated by 1 atom count. It is predicted that MA (ionic radius: 216 pm), EA (ionic radius: 274 pm), and GA (ionic radius: 278 pm) that have ionic radii close to that of FA (ionic radius: 253 pm) would also have similar compositions and a stable structure, and would be easy to synthesize.

The compound according to the first embodiment may have some Ag sites substituted with a monovalent inorganic cation. Examples of the monovalent inorganic cation that substitutes some Ag sites include cations having ionic radii close to that of Ag⁺, such as a lithium cation (ionic radius: 76 pm), a sodium cation (ionic radius: 102 pm), a potassium cation (ionic radius: 138 pm), a copper cation (ionic radius: 77 pm), and a gold cation (ion radius: 137 pm). Meanwhile, monovalent inorganic cations that have large ionic radii, such as a cesium cation (ionic radius: 167 pm) and a rubidium cation (ionic radius: 152 pm), have ionic radii close to the lower limit of the ionic radius of the organic cation A. Therefore, when substituting the Ag sites with an inorganic cation having a large ionic radius, the structure of the compound is expected to be unstable unless the ionic radius of the organic cation A is also large.

The compound according to the first embodiment may have some A sites substituted with a monovalent inorganic cation. Examples of such a monovalent inorganic cation include a lithium cation, a sodium cation, a potassium cation, a copper cation, a gold cation, a cesium cation, and a rubidium cation. Due to the difference in ionic radius, even inorganic cations normally too small to substitute the A sites can enter the A sites by way of terminating the defects.

The compound according to the first embodiment may consist of A, Ag, and X.

The compound according to the first embodiment can be synthesized by, for example, a coating method. A thin film composed of the compound of the first embodiment is formed by spin-coating a substrate with a raw material solution and heat-treating the coating solution. The raw material solution is, for example, obtained by weighing AI and silver iodide (AgI) as organic halides in a desired stoichiometric composition and dissolving these in N,N-dimethylformamide (DMF) serving as a solvent. If necessary, the raw material solution may be heated to completely dissolve these iodides. Interestingly, the present inventors have found that, although AgI alone does not dissolve in DMF, mixing AI and AgI simultaneously allows dissolution to progress. The solvent for the raw material solution preferably has a high Gutmann donor number to facilitate formation of intermediates. Examples of such a solvent include dimethylsulfoxide, tetrahydrothiophene 1-oxide, dimethylacetamide, N-methyl-2-pyrrolidone, and N,N'-dimethylpropylene urea. It has been confirmed that, as in the case of forming a typical three-dimensional perovskite compound by a coating method, adding a poor solvent dropwise during the coating formation improves the crystallinity of the compound of the first embodiment.

As with typical three-dimensional perovskite compounds, an inverse temperature crystallization method (M. I. Saidaminov, et al., Nature Communications, July 2015, Vol. 6, p. 7586.) may be used to grow single crystals. The solvent for the raw material solution used for the inverse temperature crystallization method preferably has a low Gutmann donor number or acceptor number. Examples of such a solvent include γ-butyrolactone, γ-valerolactone, ethylene carbonate, propylene carbonate, sulfolane, acetonitrile, and nitromethane.

### (Second embodiment)

Hereinafter, an electronic device according to a second embodiment is described. The matters described in the first embodiment may be omitted as appropriate.

The electronic device of the second embodiment includes the compound of the first embodiment.

The electronic device of the second embodiment can operate in the ultraviolet region since the compound of the first embodiment is contained.

The electronic device of the second embodiment includes, for example, a first electrode, a photoelectric conversion layer, and a second electrode arranged in this order. The electronic device contains the compound of the first embodiment.

The photoelectric conversion layer may contain the compound according to the first embodiment.

The electronic device of the second embodiment may further include a hole transport layer and a buffer layer, the hole transport layer may be disposed between the photoelectric conversion layer and the second electrode, the buffer layer may be disposed between the hole transport layer and the photoelectric conversion layer, and the buffer layer may contain the compound of the first embodiment.

The electronic device of the second embodiment is, for example, a photoelectric conversion device. Examples of the photoelectric conversion device include solar batteries, ultraviolet sensors, and light-emitting diodes.

Hereinafter, one example structure of when the electronic device of the second embodiment is a photoelectric conversion device is specifically described.

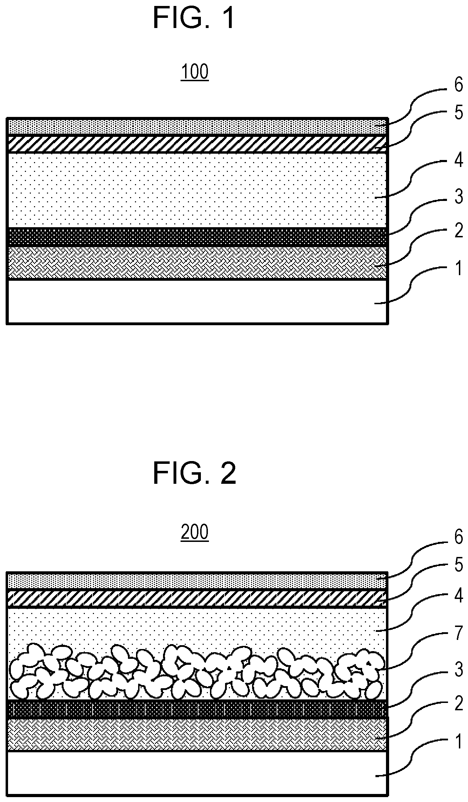

Fig. 1 is a cross-sectional view illustrating a schematic structure of a photoelectric conversion device 100 according to the second embodiment.

The photoelectric conversion device 100 of the second embodiment includes a substrate 1, a first electrode 2, an electron transport layer 3, a photoelectric conversion layer 4, a hole transport layer 5, and a second electrode 6 arranged in this order.

When the photoelectric conversion device 100 is irradiated with light, the photoelectric conversion layer 4 absorbs the light and generates excited electrons and holes. The excited electrons travel through the electron transport layer 3 to the first electrode 2. Meanwhile, the holes generated in the photoelectric conversion layer 4 travel to the second electrode 6 through the hole transport layer 5. In this manner, the photoelectric conversion device 100 can extract current from the first electrode 2 serving as a negative electrode and the second electrode 6 serving as a positive electrode.

The photoelectric conversion layer 4 may contain the compound according to the first embodiment. The compound according to the first embodiment has a large bandgap and can absorb ultraviolet light. In addition, since the compound according to the first embodiment has a valence band upper edge with a shallow energy level, holes can be easily extracted. Thus, a photoelectric conversion device having high photoelectric conversion efficiency in the ultraviolet region can be realized. Since the compound of the first embodiment is transparent, a see-through photoelectric conversion device (for example, a see-through solar battery) may be prepared.

The photoelectric conversion device 100 may have or be free of the substrate 1.

The photoelectric conversion device 100 may have or be free of the electron transport layer 3. When the photoelectric conversion device 100 has the electron transport layer 3, the photoelectric conversion device 100 can efficiently transfer electrons to the first electrode 2. As a result, the photoelectric conversion device 100 can extract current efficiently.

The photoelectric conversion device 100 may have or be free of the hole transport layer 5. When the photoelectric conversion device 100 has the hole transport layer 5, the photoelectric conversion device 100 can efficiently transfer holes to the second electrode 6. As a result, the photoelectric conversion device 100 can extract current efficiently.

The photoelectric conversion device 100 can be prepared by, for example, the following method.

First, a first electrode 2 is formed on a surface of a substrate 1 by a chemical vapor deposition method, a sputtering method, or the like. Next, an electron transport layer 3 is formed by a chemical vapor deposition method, a sputtering method, a solution coating method, or the like. Next, a photoelectric conversion layer 4 is formed on the electron transport layer 3. The photoelectric conversion layer 4 may be formed by, for example, a coating method using a solution, a printing method, a vapor deposition method, or the like. Alternatively, for example, a perovskite compound sliced to a particular thickness may be placed on the electron transport layer 3 to serve as the photoelectric conversion layer 4. Next, a hole transport layer 5 is formed on the photoelectric conversion layer 4 by a chemical vapor deposition method, a sputtering method, a solution coating method, or the like. Next, a second electrode 6 is formed on the hole transport layer 5 by a chemical vapor deposition method, a sputtering method, a solution coating method, or the like. As a result, a photoelectric conversion device 100 is obtained.

The photoelectric conversion device of the second embodiment may further include a porous layer. The porous layer is disposed, for example, between the electron transport layer and the photoelectric conversion layer.

Fig. 2 is a cross-sectional view illustrating a schematic structure of a photoelectric conversion device 200 according to the second embodiment.

The photoelectric conversion device 200 includes a substrate 1, a first electrode 2, an electron transport layer 3, a porous layer 7, a photoelectric conversion layer 4, a hole transport layer 5, and a second electrode 6 arranged in this order.

The porous layer 7 includes a porous body. The porous body includes voids.

The photoelectric conversion device 200 may have or be free of the substrate 1.

The photoelectric conversion device 200 may have or be free of the electron transport layer 3. When the photoelectric conversion device 200 does not have an electron transport layer 3, the porous layer 7 is disposed between the first electrode 2 and the photoelectric conversion layer 4. When the photoelectric conversion device 200 has the electron transport layer 3, the electrons can travel efficiently to the first electrode 2. As a result, the photoelectric conversion device 200 can extract current efficiently.

The photoelectric conversion device 200 may have or be free of the hole transport layer 5. When the photoelectric conversion device 200 has the hole transport layer 5, holes can be efficiently transferred to the second electrode 6. As a result, the photoelectric conversion device 200 can extract current efficiently.

The photoelectric conversion device of the second embodiment may further include an intermediate layer. The intermediate layer is disposed, for example, between the porous layer and the photoelectric conversion layer.

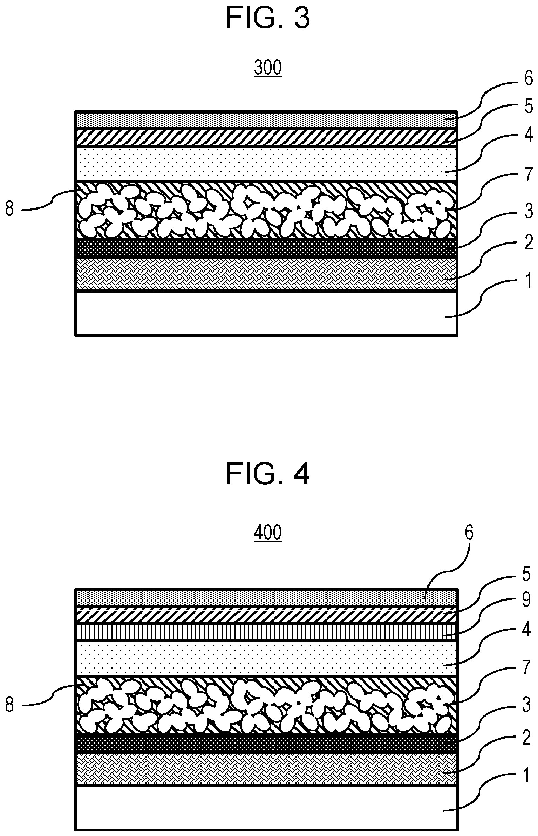

Fig. 3 is a cross-sectional view illustrating a schematic structure of a photoelectric conversion device 300 according to the second embodiment.

The photoelectric conversion device 300 includes a substrate 1, a first electrode 2, an electron transport layer 3, a porous layer 7, an intermediate layer 8, a photoelectric conversion layer 4, a hole transport layer 5, and a second electrode 6 arranged in this order.

The photoelectric conversion device 300 may have or be free of the substrate 1.

The photoelectric conversion device 300 may have or be free of the electron transport layer 3. When the photoelectric conversion device 300 has the electron transport layer 3, the electrons can travel efficiently to the first electrode 2. As a result, the photoelectric conversion device 300 can extract current efficiently.

The photoelectric conversion device 300 may have or be free of the porous layer 7. When the photoelectric conversion device 300 does not have a porous layer 7, the intermediate layer 8 is disposed between the electron transport layer 3 and the photoelectric conversion layer 4.

The photoelectric conversion device 300 may have or be free of the hole transport layer 5. When the photoelectric conversion device 300 has the hole transport layer 5, holes can be efficiently transferred to the second electrode 6. As a result, the photoelectric conversion device 300 can extract current efficiently.

The photoelectric conversion device of the second embodiment may further include a buffer layer. The buffer layer is disposed, for example, between the photoelectric conversion layer and the hole transport layer.

The buffer layer may contain the compound according to the first embodiment.

In the photoelectric conversion device of the second embodiment, the photoelectric conversion layer may be free of the compound of the first embodiment, and the buffer layer may contain the compound of the first embodiment.

Fig. 4 is a cross-sectional view illustrating a schematic structure of a photoelectric conversion device 400 according to the second embodiment.

The photoelectric conversion device 400 includes a substrate 1, a first electrode 2, an electron transport layer 3, a porous layer 7, an intermediate layer 8, a photoelectric conversion layer 4, a buffer layer 9, a hole transport layer 5, and a second electrode 6 arranged in this order.

The photoelectric conversion device 400 may have or be free of the substrate 1.

The photoelectric conversion device 400 may have or be free of the electron transport layer 3. When the photoelectric conversion device 400 has the electron transport layer 3, the electrons can travel efficiently to the first electrode 2. As a result, the photoelectric conversion device 400 can extract current efficiently.

The photoelectric conversion device 400 may have or be free of the porous layer 7.

The photoelectric conversion device 400 may have or be free of the intermediate layer 8.

The photoelectric conversion device 400 may have or be free of the hole transport layer 5. When the photoelectric conversion device 400 does not have a hole transport layer 5, the buffer layer 9 is disposed between the photoelectric conversion layer 4 and the second electrode 6.

Hereinafter, individual constituent elements of the photoelectric conversion device are specifically described.

### (Substrate 1)

The substrate 1 is an optional element. The substrate 1 plays the role of supporting the individual layers of the photoelectric conversion device. The substrate 1 can be prepared from a transparent material. For example, a glass substrate or a plastic substrate can be used as the substrate 1. The plastic substrate may be, for example, a plastic film.

When the second electrode 6 has a light-transmitting property, the substrate 1 may be prepared from a material that has no light-transmitting property. A metal, a ceramic, or a resin material with a low light-transmitting property can be used as such a material.

When the first electrode 2 has sufficient strength, the substrate 1 may be omitted since the first electrode 2 can support the layers.

### (First electrode 2)

The first electrode 2 has electrical conductivity.

The first electrode 2 has a light-transmitting property. For example, light in the visible to near-infrared region can be transmitted.

The first electrode 2 is composed of a material that is transparent and electrically conductive. Examples of such a material include metal oxides and metal nitrides. Examples of such materials include (i) titanium oxide doped with at least one selected from the group consisting of lithium, magnesium, niobium, and fluorine; (ii) gallium oxide doped with at least one selected from the group consisting of tin and silicon; (iii) gallium nitride doped with at least one selected from the group consisting of silicon and oxygen; (iv) tin oxide doped with at least one selected from the group consisting of antimony and fluorine; (v) zinc oxide doped with at least one selected from the group consisting of boron, aluminum, gallium, and indium; (vi) indium-tin complex oxides; and (vii) hybrid materials thereof.

The first electrode 2 may be formed to have a light-transmitting pattern. Examples of the light-transmitting pattern include a straight line pattern, a wavy line pattern, a lattice pattern, and a punched metal pattern in which a large number of fine through holes are regularly or irregularly arranged. When the first electrode 2 has these patterns, light can pass through the areas where the electrode material is absent. Thus, by forming a light-transmitting pattern, a non-transparent material can be used. Examples of non-transparent electrode material include platinum, gold, silver, copper, aluminum, rhodium, indium, titanium, iron, nickel, tin, zinc, and alloys containing any of the foregoing. A conductive carbon material may be used as the non-transparent electrode material.

When the photoelectric conversion device lacks the electron transport layer 3, the first electrode 2 has a property to block holes from the photoelectric conversion layer 4. In this case, the first electrode 2 does not make ohmic contact with the photoelectric conversion layer 4. Furthermore, the property to block holes from the photoelectric conversion layer 4 refers to a property of allowing only electrons generated in the photoelectric conversion layer 4 to pass but not the holes. The Fermi energy of a material having this property is higher than the energy of the valence band upper edge of the photoelectric conversion layer 4. The Fermi energy of a material having this property may be higher than the Fermi energy of the photoelectric conversion layer 4. A specific example of the material is aluminum.

When the photoelectric conversion device includes an electron transport layer 3, the first electrode 2 does not have to have a property to block holes from the photoelectric conversion layer 4. In this case, the first electrode 2 can be composed of a material that is capable of forming ohmic contact with the photoelectric conversion layer 4. In this case, the first electrode 2 does not have to make ohmic contact with the photoelectric conversion layer 4.

The light transmittance of the first electrode 2 may be, for example, greater than or equal to 50% or greater than or equal to 80%. The wavelength of the light to be transmitted by the first electrode 2 depends on the absorption wavelength of the photoelectric conversion layer 4.

The thickness of the first electrode 2 may be, for example, greater than or equal to 1 nm and less than or equal to 1000 nm.

### (Electron transport layer 3)

The electron transport layer 3 contains a semiconductor. The electron transport layer 3 may be prepared from a semiconductor having a bandgap greater than or equal to 3.0 eV. In this manner, visible and infrared light can be transmitted to the photoelectric conversion layer 4. An example of the semiconductor is an inorganic n-type semiconductor.

Examples of inorganic n-type semiconductor include metal oxides, metal nitrides, and perovskite oxides. Examples of metal oxides include oxides of Cd, Zn, In, Pb, Mo, W, Sb, Bi, Cu, Hg, Ti, Ag, Mn, Fe, V, Sn, Zr, Sr, Ga, Si, and Cr. The metal oxide is, for example, TiO₂ or SnO₂. The metal nitride is, for example, GaN. The perovskite oxide is, for example, SrTiO₃ or CaTiO₃.

In particular, in order to effectively transmit ultraviolet light to the photoelectric conversion layer 4, a semiconductor having a bandgap greater than or equal to 6.0 eV may be used in the electron transport layer 3. Examples of such a semiconductor include halides of alkali metals or alkaline earth metals such as lithium fluoride and calcium fluoride, alkali metal oxides such as magnesium oxide, and silicon dioxide. In this case, in order to ensure the electron transport property of the electron transport layer 3, the electron transport layer 3 may have a thickness less than or equal to 10 nm, for example.

The electron transport layer 3 may include multiple layers composed of different materials.

### (Photoelectric conversion layer 4)

The photoelectric conversion layer 4 contains a photoelectric conversion material.

The photoelectric conversion material may be, for example, a perovskite compound. In other words, the photoelectric conversion layer 4 may contain a perovskite compound. Perovskite compounds have high light absorption coefficients in the wavelength range of the sunlight spectrum, and high carrier mobility. Therefore, photoelectric conversion devices containing perovskite compounds have high photoelectric conversion efficiency.

The perovskite compound may be, for example, a three-dimensional perovskite compound represented by the formula A'BX₃. Here, A' is a monovalent cation. Examples of the monovalent cation include alkali metal cations and organic cations. Examples of the alkali metal cations include a potassium cation (K⁺), a cesium cation (Cs⁺), and a rubidium cation (Rb⁺). Examples of the organic cations include a methylammonium cation (MA⁺), a formamidinium cations (FA⁺), an ethylammonium cation (EA⁺), and a guanidinium cation (GA⁺). B is a divalent cation. Examples of the divalent cation include a lead cation (Pb²⁺) and a tin cation (Sn²⁺). X is a monovalent anion. An example of a monovalent anion is a halogen anion. The A, B, and X sites may each be occupied by more than one types of ions.

As mentioned above, the photoelectric conversion layer 4 may contain the compound according to the first embodiment.

The thickness of the photoelectric conversion layer 4 is, for example, greater than or equal to 50 nm and less than or equal to 10 µm.

The photoelectric conversion layer 4 can be formed by a coating method using a solution, a printing method, or a vapor deposition method. The photoelectric conversion layer 4 may be formed by placing a slice of a three-dimensional perovskite compound.

The photoelectric conversion layer 4 may mainly contain a three-dimensional perovskite compound represented by a formula A'BX₃. Here, "the photoelectric conversion layer 4 mainly contains a three-dimensional perovskite compound represented by a formula A'BX₃" means that the photoelectric conversion layer 4 contains 90 mass% or more of a three-dimensional perovskite compound represented formula A'BX₃. The photoelectric conversion layer 4 may contain 95 mass% or more of a three-dimensional perovskite compound represented by formula A'BX₃. The photoelectric conversion layer 4 may consist of a three-dimensional perovskite compound represented by formula A'BX₃. The photoelectric conversion layer 4 may contain defects or impurities as long as a three-dimensional perovskite compound represented by formula A'BX₃ is contained.

The photoelectric conversion layer 4 may further contain a compound different from the three-dimensional perovskite compound represented by formula A'BX₃. Examples of the different compound include Ruddlesden-Popper layered perovskite compounds.

In particular, when ultraviolet light is to be absorbed effectively by the photoelectric conversion layer 4, the photoelectric conversion layer 4 may contain the compound according to the first embodiment.

### (Hole transport layer 5)

The hole transport layer 5 contains a hole transport material. The hole transport material is a material that transports holes. The hole transport material is, for example, an organic semiconductor or inorganic semiconductor.

Examples of the organic semiconductor include triphenylamine, triallylamine, phenylbenzidine, phenylene vinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Representative examples of the organic semiconductor used as a hole transport material include 2,2',7,7'-tetrakis-(N,N-di-p-methoxyphenylamine)9,9'-spirobifluorene, poly[bis(4-phenyl)(2,4,6-trimethylphenyl)amine] (hereinafter, also referred to as "PTAA"), poly(3-hexylthiophene-2,5-diyl), poly(3,4-ethylenedioxythiophene), and copper phthalocyanine.

The inorganic semiconductor used as a hole transport material is a p-type semiconductor. Examples of the inorganic semiconductor include Cu₂O, CuGaO₂, CuSCN, CuI, NiOₓ, MoOₓ, V₂O₅, and carbon materials such as graphene oxide. Here, x > 0.

The hole transport layer 5 may include multiple layers composed of different materials. For example, the hole transport properties are improved by stacking multiple layers in such a manner that the ionization potential of the hole transport layer 5 gradually decreases with respect to the ionization potential of the photoelectric conversion layer 4.

The thickness of the hole transport layer 5 may be greater than or equal to 1 nm and less than or equal to 1000 nm, or may be greater than or equal to 10 nm and less than or equal to 50 nm. In this manner, sufficient hole transport properties can be exhibited. Thus, the solar battery can maintain low resistance, and high photoelectric conversion efficiency can be achieved.

The hole transport layer 5 is, for example, formed by a coating method, a printing method, or a vapor deposition method. This is the same as the photoelectric conversion layer 4. Examples of the coating method include a doctor blade method, a bar coating method, a spraying method, a dip coating method, and a spin coating method. An example of the printing method is a screen printing method. If necessary, multiple materials may be mixed to create a hole transport layer 5, which may be pressed or heat-treated. When the material for the hole transport layer 5 is an organic low-molecular-weight material or an inorganic semiconductor, it is possible to prepare the hole transport layer 5 by a vacuum vapor deposition method.

The hole transport layer 5 may contain additives in addition to the hole transport material in order to enhance conductivity. Examples of the additives include a supporting electrolyte, a solvent, and a dopant. The supporting electrolyte and the solvent have an effect of stabilizing the holes in the hole transport layer 5. The dopant has an effect of increasing the number of holes in the hole transport layer 5.

Examples of the supporting electrolyte include ammonium salts, alkaline earth metal salts, and transition metal salts. Examples of the ammonium salts include tetrabutylammonium perchlorate, tetraethylammonium hexafluorophosphate, imidazolium salts, and pyridinium salts. Example of an alkali metal salt include lithium perchlorate and potassium tetrafluoroborate. An example of the alkaline earth metal salts is bis(trifluoromethanesulfonyl)imide calcium(II). Examples of the transition metal salts include bis(trifluoromethanesulfonyl)imide zinc(II) and tris[4-tert-butyl-2-(1H-pyrazol-1-yl)pyridine]cobalt(III) tris(trifluoromethanesulfonyl)imide.

An example of the dopant is a fluorine-containing aromatic boron compound. An example of the fluorine-containing aromatic boron compound is tris(pentafluorophenyl)b orane.

The solvent contained in the hole transport layer 5 may have excellent ionic conductivity. The solvent may be an aqueous solvent or an organic solvent. To further stabilize the solute, the solvent contained in the hole transport layer 5 may be an organic solvent. Examples of the organic solvent include heterocyclic compound solvents such as tert-butylpyridine, pyridine, and n-methylpyrrolidone.

An ionic liquid may be used as the solvent. The ionic liquid may be used alone or mixed with other solvents and used. The ionic liquid is preferable for its low volatility and high flame retardancy.

Examples of the ionic liquid include imidazolium-based ionic liquids such as 1-ethyl-3-methylimidazolium tetracyanoborate, and pyridine-based, alicyclic amine-based, aliphatic amine-based, and azonium amine-based ionic liquids.

### (Second electrode 6)

The second electrode 6 has electrical conductivity.

When the photoelectric conversion device does not include a hole transport layer 5, the second electrode 6 has a property to block electrons from the photoelectric conversion layer 4. In this case, the second electrode 6 does not make ohmic contact with the photoelectric conversion layer 4. The property to block electrons from the photoelectric conversion layer 4 refers to a property of allowing only holes generated in the photoelectric conversion layer 4 to pass but not the electrons. The Fermi energy of a material having this property is lower than the energy of the conduction band lower edge of the photoelectric conversion layer 4. The Fermi energy of the material having this property may be lower than the Fermi energy of the photoelectric conversion layer 4. Specific examples of the material include platinum, gold, and carbon materials such as graphene.

When the photoelectric conversion device includes a hole transport layer 5, the second electrode 6 does not have to have a property to block electrons from the photoelectric conversion layer 4. In this case, the second electrode 6 can be composed of a material that is capable of forming ohmic contact with the photoelectric conversion layer 4. In this manner, the second electrode 6 can be formed to have a light-transmitting property.

Of the first electrode 2 and the second electrode 6, the electrode on the light-incident side is to have a light-transmitting property. Thus, one of the first electrode 2 and the second electrode 6 does not have to have a light-transmitting property. In other words, one of the first electrode 2 and the second electrode 6 does not have to use a light-transmitting material or does not have to have a pattern that includes opening portions that transmit light.

### (Porous layer 7)

The porous layer 7 is formed on the electron transport layer 3 by, for example, a coating method. When the photoelectric conversion device does not include the electron transport layer 3, the porous layer 7 is formed on the first electrode 2.

The pore structure introduced by porous layer 7 lays the foundation for forming the photoelectric conversion layer 4. The porous layer 7 does not inhibit light absorption of the photoelectric conversion layer 4 and the transfer of electrons from the photoelectric conversion layer 4 to the electron transport layer 3.

The porous layer 7 includes a porous body.

The porous body is formed, for example, by continuation of insulating or semiconductor particles. Examples of the insulating particles include aluminum oxide particles and silicon oxide particles. An example of the semiconductor particles is inorganic semiconductor particles. Examples of the inorganic semiconductor include metal oxides, perovskite oxides of metal elements, sulfides of metal elements, and metal chalcogenides. Examples of the metal oxide include oxides of Cd, Zn, In, Pb, Mo, W, Sb, Bi, Cu, Hg, Ti, Ag, Mn, Fe, V, Sn, Zr, Sr, Ga, Si, and Cr. The metal oxide is, for example TiO₂. Examples of the perovskite oxides of metal elements include SrTiO₃ and CaTiO₃. Examples of the sulfides of metal elements include CdS, ZnS, In₂S₃, PbS, Mo₂S, WS₂, Sb₂S₃, Bi₂S₃, ZnCdS₂, and Cu₂S. Examples of the metal chalcogenides include CsSe, In₂Se₃, WSe₂, HgS, PbSe, and CdTe.

The thickness of the porous layer 7 may be greater than or equal to 0.01 µm and less than or equal to 10 µm or may be greater than or equal to 0.05 µm and less than or equal to 1 µm.

The surface roughness of the porous layer 7 in terms of a surface roughness coefficient given by effective area/projected area may be greater than or equal to 10 or greater than or equal to 100. The projected area is the area of a shadow that forms when an object is irradiated with light from directly front. The effective area is the actual surface area of an object. The effective area can be calculated from the volume obtained from the projected area and thickness of the object, and the specific surface area and bulk density of the material that constitutes the object. The specific surface area is measured, for example, by a nitrogen adsorption method.

The voids in the porous layer 7 are connected from one main face of the porous layer 7 to the other. In other words, the voids in the porous layer 7 are connected from the main face of the porous layer 7 in contact with the photoelectric conversion layer 4 to the main face of the porous layer 7 in contact with the electron transport layer 3. In this manner, the material of the photoelectric conversion layer 4 fills the voids in the porous layer 7 and can reach the surface of the electron transport layer 3. Thus, the photoelectric conversion layer 4 and the electron transport layer 3 are in direct contact with each other and can exchange electrons.

By providing the porous layer 7, an effect of facilitating formation of the photoelectric conversion layer 4 can be obtained. By providing the porous layer 7, the material for the photoelectric conversion layer 4 enters the voids in the porous layer 7, and the porous layer 7 serves as a scaffold for the photoelectric conversion layer 4. Thus, the material for the photoelectric conversion layer 4 is less likely to be repelled by or become aggregated on the surface of the porous layer 7. Thus, the photoelectric conversion layer 4 can be easily formed as an even film. The photoelectric conversion layer 4 can be formed by the aforementioned coating method, printing method, vapor deposition method, or the like.

Since the porous layer 7 scatters light, an effect of increasing the optical path length of light passing through the photoelectric conversion layer 4 can also be expected. It is expected that the increase in optical path length increases the amount of electrons and holes generated in the photoelectric conversion layer 4.

### (Intermediate layer 8)

The intermediate layer 8 includes fullerene (C₆₀), a C₆₀ derivative, or a self-assembled monolayer (hereinafter may also be referred to as "C60SAM") containing C₆₀. Since the intermediate layer 8 efficiently collects electrons, the resistance loss in transporting electrons to the electron transport layer 3 is reduced.

Examples of the C₆₀ derivative include [6,6]-phenyl C₆₁ butyric acid methyl ester and [6,6]-phenyl-C₆₁ butyric acid butyl ester. Examples of C60SAM include 4-(1',5'-dihydro-1'-methyl-2'H-[5,6]fullereno-C₆₀-Ih-[1,9-c]pyrrol-2'-yl)benzoic acid, (1,2-methanofullerene C₆₀)-61-carboxylic acid, and C₆₀ pyrrolidine tris-acid.

The intermediate layer 8 is, for example, formed by a coating method using a solution, an immersion method, a printing method, or a vapor deposition method.

### (Buffer layer 9)

The buffer layer 9 has such functions as terminating the defects in the photoelectric conversion layer 4, inhibiting entry of outside air (oxygen, moisture, etc.) into the photoelectric conversion layer 4, suppressing desorption of decomposition gas (iodine, methyl amine, etc.) generated in the photoelectric conversion layer 4, and having an energy level that can improve hole extraction.

The buffer layer 9 may contain the compound according to the first embodiment. The buffer layer 9 containing the compound of the first embodiment inhibits the desorption of decomposition gas generated in the photoelectric conversion layer 4 and can improve hole extraction. This is possible because the compound of the first embodiment has a valence band upper edge between the energy level of the valence band upper edge of the photoelectric conversion layer 4 and the highest occupied molecular orbital (HOMO) level of the hole transport layer 5. For example, it is known that, when the photoelectric conversion layer 4 contains a three-dimensional perovskite compound, heating causes desorption of iodine, methylamine, etc., from the perovskite compound; however, the buffer layer 9 containing the compound of the first embodiment terminates the defects in the perovskite, can suppress desorption of the decomposition gas passing through the defects, and does not obstruct hole extraction. As a result, desorption of iodine, methyl amine, etc., can be effectively suppressed. Thus, the heat resistance of the photoelectric conversion device can be prominently improved.

### (Third embodiment)

Hereinafter, a light-emitting device according to a second embodiment is described. The matters described in the first and second embodiments may be omitted as appropriate.

The light-emitting device of the third embodiment contains the compound of the first embodiment.

The light-emitting device of the third embodiment includes, for example, an emission layer, and the emission layer contains the compound of the first embodiment.

The light-emitting device of the third embodiment can emit light upon absorbing ultraviolet light by containing the compound of the first embodiment. For example, the light-emitting device of the third embodiment emits light by absorbing ultraviolet light.

The light-emitting device of the third embodiment can be used as a phosphor of an LED lamp, a plasma display, etc., for example.

### EXAMPLES

The present disclosure will now be described in further detail by referring to Examples and Comparative Examples.

In Examples, silver-halogen compounds were prepared so as to confirm the absence/presence of impurity phases therein by X-ray diffractometry (XRD), evaluate the optical bandgap by transmittance measurement, evaluate the work function (that is, the energy at the valence band upper edge) by atmospheric photoelectron spectroscopy, and evaluate emission intensity by photoluminescence measurement. In addition, photoelectric conversion devices that used the prepared silver-halogen compounds in the buffer layers were prepared, and the initial characteristics and the characteristics after heat resistance test of these photoelectric conversion devices were evaluated.

### <Preparation of compounds >

### (Example 1)

First, a DMF solution containing CH₃NH₃I (hereinafter referred to as "MAI") and AgI as solutes was prepared. The concentration of MAI in the solution was 1 mol/L and the concentration of AgI in the solution was 1 mol/L. The solutes were completely dissolved by heat-treating this solution on a hot plate at a temperature higher than or equal to 60°C and lower than or equal to 70°C.

Next, the resulting solution was applied to a substrate by a spin coating method. A glass substrate with a thickness of 0.7 mm was used as the substrate. Subsequently, the substrate was heat-treated on a 100°C hot plate for 10 minutes. As a result, a compound of Example 1 represented by MAAgI₂ was obtained.

### (Example 2)

In Example 2, HC(NH₂)₂I (hereinafter referred to as "FAI") was used as a solute instead of MAI. A compound of Example 2 represented by FAAgI₂ was obtained as in Example 1 except for this feature.

### (Example 3)

In Example 3, CH₃CH₂NH₃I (hereinafter referred to as "EAI") was used as a solute instead of MAI. A compound of Example 3 represented by EAAgI₂ was obtained as in Example 1 except for this feature.

### (Example 4)

In Example 4, C((NH)₂)₃I (hereinafter referred to as "GAI") was used as a solute instead of MAI. A compound of Example 4 represented by GAAgI₂ was obtained as in Example 1 except for this feature.

### (Example 5)

First, a DMF solution containing MAI and AgI as solutes was prepared. The concentration of MAI in the solution was 0.5 mol/L and the concentration of AgI in the solution was 1 mol/L.

Next, the resulting solution was applied to a substrate by a spin coating method. A glass substrate with a thickness of 0.7 mm was used as the substrate. Subsequently, the substrate was heat-treated on a 100°C hot plate for 10 minutes. As a result, a compound of Example 5 represented by MAAg₂I₃ was obtained.

### (Example 6)

In Example 6, FAI was used as a solute instead of MAI. A compound of Example 6 represented by FAAg₂I₃ was obtained as in Example 5 except for this feature.

### (Example 7)

In Example 7, EAI was used as a solute instead of MAI. A compound of Example 7 represented by EAAg₂I₃ was obtained as in Example 5 except for this feature.

### (Example 8)

In Example 8, GAI was used as a solute instead of MAI. A compound of Example 8 represented by GAAg₂I₃ was obtained as in Example 5 except for this feature.

### (Example 9)

In Example 9, FABr was used as a solute instead of MAI, and AgBr was used as a solute instead of AgI. A compound of Example 9 represented by FAAgBr₂ was obtained as in Example 1 except for this feature.

### (Example 10)

In Example 10, EABr was used as a solute instead of MAI and AgBr was used as a solute instead of AgI. A compound of Example 10 represented by EAAgBr₂ was obtained as in Example 1 except for this feature.

### (Example 11)

First, a DMF solution containing FAI and AgI as solutes was prepared. The concentration of FAI in the solution was 1 mol/L and the concentration of AgI in the solution was 0.5 mol/L.

Next, the resulting solution was applied to a substrate by a spin coating method. A glass substrate with a thickness of 0.7 mm was used as the substrate. Subsequently, the substrate was heat-treated on a 100°C hot plate for 10 minutes. As a result, a compound of Example 11 represented by FA₂AgI₃ was obtained.

### (Example 12)

In Example 12, EAI was used as a solute instead of FAI. A compound of Example 12 represented by EA₂AgI₃ was obtained as in Example 11 except for this feature.

### (Example 13)

In Example 13, FABr was used as a solute instead of FAI, and AgBr was used as a solute instead of AgI. A compound of Example 13 represented by FA₂AgBr₃ was obtained as in Example 11 except for this feature.

### (Example 14)

In Example 14, EABr was used as a solute instead of FAI and AgBr was used as a solute instead of AgI. A compound of Example 14 represented by EA₂AgBr₃ was obtained as in Example 11 except for this feature.

### (Example 15)

In Example 15, FACl was used as a solute instead of FAI, and AgCl was used as a solute instead of AgI. A compound of Example 15 represented by FA₂AgCl₃ was obtained as in Example 11 except for this feature.

Photoelectric conversion devices of Example 16 and Comparative Example 1 were prepared as below. The structure of each photoelectric conversion device was as follows.
· Substrate: glass substrate (thickness: 0.7 mm)
· First electrode: transparent electrode, indium-tin complex oxide layer (thickness: 200 nm)
· Electron transport layer: titanium oxide (TiO₂) (thickness: 10 nm)
· Porous layer: meso porous structure titanium oxide (TiO₂)
· Intermediate layer: 4-(1',5'-dihydro-1'-methyl-2'H-[5,6]fullereno-C₆₀-Ih-[1,9-c]pyrrol-2'-yl)benzoic acid (in other words, C60SAM) (produced by Sigma-Aldrich CO. LLC)
· Photoelectric conversion layer: layer mainly containing HC(NH₂)₂PbI₃ (thickness: 500 nm)
· Buffer layer: layer containing EAAg₂I₃ or n-butylammonium bromide (produced by Greatcell Solar Materials)
· Hole transport layer: layer mainly containing PTAA (however, as an additive, tris(pentafluorophenyl)borane (TPFPB) (Tokyo Chemical Industry Co., Ltd.) (thickness: 50 nm)
· Second electrode: Au (thickness: 200 nm)

### <Fabrication of photoelectric conversion devices>

### (Example 16)

First, a glass substrate with a thickness of 0.7 mm was prepared.

A layer of an indium-tin complex oxide was formed on the substrate by a sputtering method. As a result, a first electrode was formed.

Next, a titanium oxide layer was formed on the first electrode by a sputtering method. As a result, an electron transport layer was formed.

After 30NR-D (produced by Greatcell Solar Materials) was applied to the electron transport layer by a spin coating method, the applied solution was heat-treated at 500°C for 30 minutes to form a titanium oxide layer having a meso porous structure. As a result, a porous layer was formed.

The substrate onto which layers up to the porous layer had been formed was immersed in a C60SAM solution for 30 minutes and then removed. Here, the C60SAM solution was obtained by adding C60SAM to a 1:1 (volume) mixture of tetrahydrofuran (FUJIFILM Wako Pure Chemical Corporation) and ethanol (FUJIFILM Wako Pure Chemical Corporation) so that the concentration of C60SAM was 1 × 10⁻⁵ mol/L. The removed substrate was thoroughly rinsed with an ethanol solution and then was annealed on a hot plate at 100°C for 30 minutes. After the annealing, the substrate was let cool naturally to room temperature to obtain a substrate modified with C60SAM. As a result, an intermediate layer was formed.

Next, a raw material solution of a photoelectric conversion material was applied by spin coating to form a photoelectric conversion layer containing a three-dimensional perovskite compound. The raw material solution contained 0.92 mol/L of lead(II) iodide (produced by Tokyo Chemical Industry Co., Ltd.), 0.17 mol/L of lead(II) bromide (produced by Tokyo Chemical Industry Co., Ltd.), 0.83 mol/L of formamidinium iodide (produced by Greatcell Solar Materials), 0.17 mol/L of methylammonium bromide (produced by Greatcell Solar Materials), 0.05 mol/L cesium iodide (produced by Iwatani Corporation), and 0.05 mol/L rubidium iodide (produced by Iwatani Corporation). The solvent of the solution was a mixture of dimethylsulfoxide (DMSO) (produced by acros) and DMF (produced by acros). The mixing ratio (DMSO:DMF) of DMSO to DMF in the raw material solution was 1:4 on a volume basis.

Next, a buffer layer was formed on the photoelectric conversion layer by applying a raw material solution of a buffer material by a spin coating method. The solvent of the raw material solution of the buffer material was 2-propanol (produced by FUJIFILM Wako Pure Chemical Corporation). The raw material solution of the buffer material contained less than 6.5×10⁻³ mol/L of EAAg₂I₃.

Next, a hole transport layer was formed on the buffer layer by applying a raw material solution of a hole transport material by a spin coating method. The solvent of the raw material solution of the hole transport material was toluene (produced by acros). The raw material solution of the hole transport material contained 10g/L of PTAA and TPFPB.

Next, a second electrode was formed by depositing an Au film on the hole transport layer by vacuum vapor deposition.

As a result, a photoelectric conversion device of Example 16 was obtained.

### (Example 17)

In Example 17, no porous layer was formed. The raw material solution of the photoelectric conversion material contained 0.84 mol/L of lead(II) iodide (produced by Tokyo Chemical Industry Co., Ltd.), 0.25 mol/L of lead(II) bromide (produced by Tokyo Chemical Industry Co., Ltd.), 0.73 mol/L of formamidinium iodide (produced by Greatcell Solar Materials), 0.02 mol/L of methylammonium iodide (produced by Greatcell Solar Materials), 0.15 mol/L of methylammonium bromide (produced by Greatcell Solar Materials), 0.1 mol/L of formamidinium bromide (produced by Greatcell Solar Materials), 0.05 mol/L of cesium iodide (produced by Iwatani Corporation), and 0.025 mol/L of rubidium iodide (produced by Iwatani Corporation), and the raw material solution of the buffer material contained FAAgBr₂ instead of EAAg₂I₃. A photoelectric conversion device of Example 17 was obtained as in Example 16 except for this feature.

### (Example 18)

In Example 18, the raw material solution of the buffer material contained EAAgBr₂ instead of FAAgBr₂. A photoelectric conversion device of Example 18 was obtained as in Example 17 except for this feature.

### (Comparative Example 1)

In Comparative Example 1, the raw material solution of the buffer material contained n-butylammonium bromide instead of EAAg₂I₃. A photoelectric conversion device of Comparative Example 1 was obtained as in Example 16 except for this feature.

### (Comparative Example 2)

In Comparative Example 2, the raw material solution of the buffer material contained n-butylammonium bromide instead of FAAgBr₂. A photoelectric conversion device of Comparative Example 2 was obtained as in Example 17 except for this feature.

### <Crystal structural analysis >

X-ray diffractometry was performed on the compounds of Examples 1 to 15 by using CuKα radiation. The measurement wavelength was 0.15405 nm, and a fully automatic horizontal multipurpose X-ray diffractometer (SmartLab produced by Rigaku Corporation) was used.

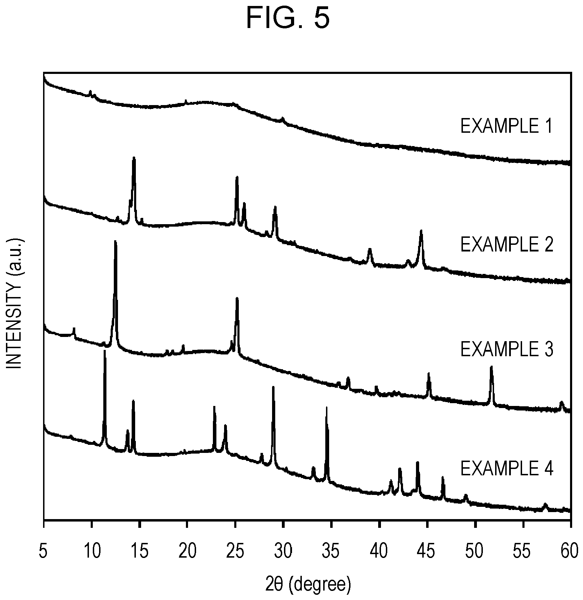

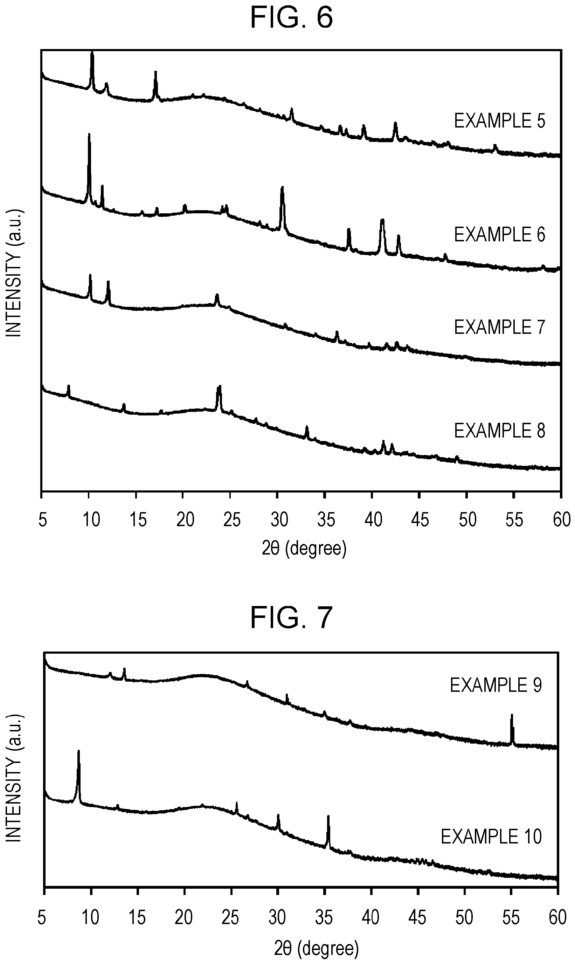

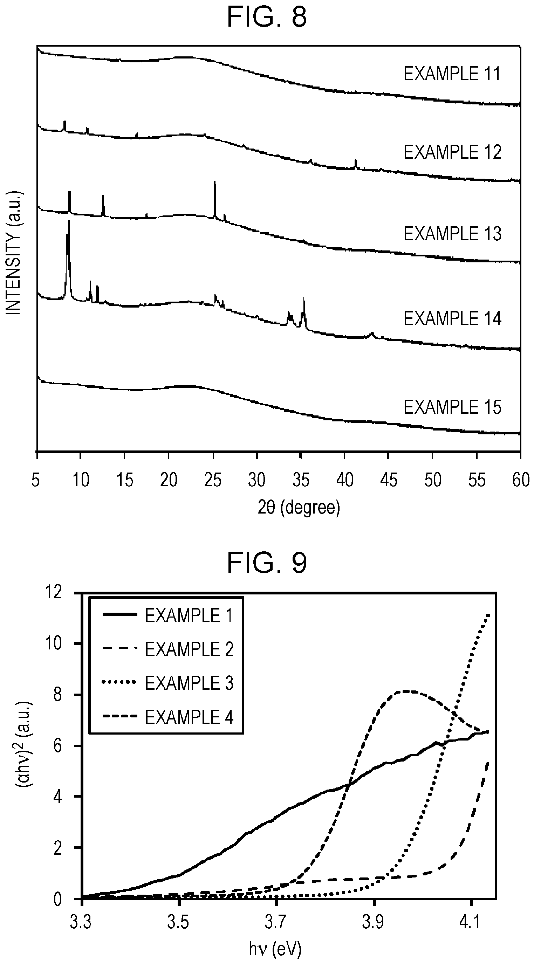

Fig. 5 is a graph illustrating X-ray diffraction patterns of compounds of Examples 1 to 4. In other words, Fig. 5 is a graph illustrating X-ray diffraction patterns of the AAgI₂ compounds of Examples 1 to 4. Fig. 6 is a graph illustrating X-ray diffraction patterns of compounds of Examples 5 to 8. In other words, Fig. 6 is a graph illustrating X-ray diffraction patterns of the AAg₂I₃ compounds of Examples 5 to 8. Fig. 7 is a graph illustrating X-ray diffraction patterns of compounds of Examples 9 and 10. In other words, Fig. 7 is a graph illustrating X-ray diffraction patterns of the AAgBr₂ compounds of Examples 9 and 10. Fig. 8 is a graph illustrating X-ray diffraction patterns of compounds of Examples 11 to 15. In other words, Fig. 8 is a graph illustrating X-ray diffraction patterns of the A₂AgX₃ compounds of Examples 11 to 15. In Figs. 5 to 8, the horizontal axis indicates the diffraction angle 2θ, and the vertical axis indicates the X-ray diffraction intensity.

Figs. 5 to 8 confirmed that the compounds of Examples 1 to 15 did not contain the raw material (AX or AgX) as impurities. In addition, although the compound of Example 4 contained some amount of the compound of Example 8, in all other Examples, a single phase was obtained. In Examples 11 and 15, the main peaks were detected at around 14.47°and 9.61°, respectively, but their X-ray diffraction intensities were very low.

Comparisons of Examples 1 to 4, 5 to 8, and 11 to 15 reveals that the peak positions are notably different in the X-ray diffraction patterns. This shows that AAgI₂ compounds, AAg₂I₃ compounds, and A₂AgX₃ compounds have crystal structures different from each other. For example, the compound of Example 7 represented by EAAg₂I₃ could be indexed as orthorhombic and had lattice constants of a = 8.69 Å, b = 13.1 Å, c = 9.58 Å, and α = 90.0°.

### <Tauc plots>

The transmittances of the compounds of Examples 1 to 15 were measured by using a spectrophotometer (Solidspec-3700 produced by Shimadzu Corporation). The wavelength was 190 nm or 300 nm to 1400 nm. The absorption coefficient α was calculated from the transmittance T, and a Tauc plot was drawn on the horizontal axis indicating the light energy hv and the vertical axis indicating (αhv)².

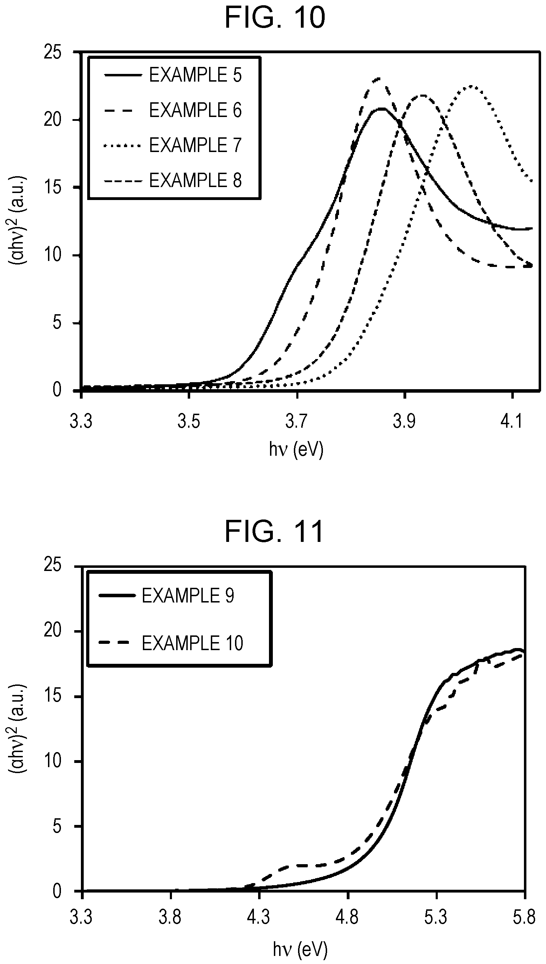

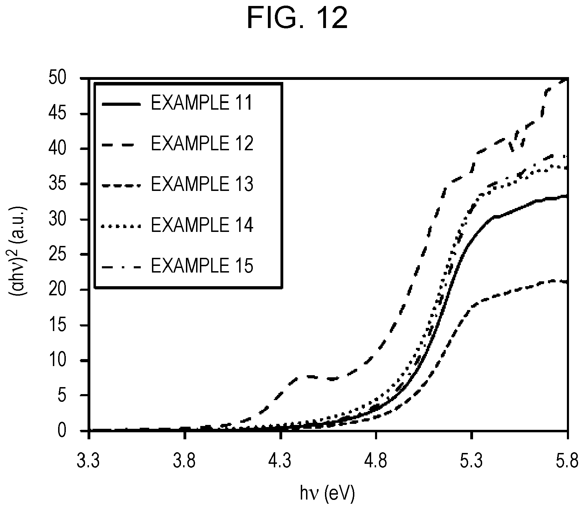

Fig. 9 is a graph illustrating Tauc plots of the compounds of Examples 1 to 4. Fig. 10 is a graph illustrating Tauc plots of the compounds of Examples 5 to 8. Fig. 11 is a graph illustrating Tauc plots of the compounds of Examples 9 and 10. Fig. 12 is a graph illustrating Tauc plots of the compounds of Examples 11 to 15.

The optical bandgap can be estimated from the intersection between the horizontal axis and a straight line obtained by line-fitting the vicinity of the inflection point of the Tauc plot. Table 1 indicates the bandgaps E_{g} of the compounds of Examples 1 to 15. As indicated in Table 1, the E_{g} of the compounds of Examples 1 to 15 were in the range of 3.38 eV to 4.93 eV.

### <Work function>

The work functions of the compounds of Examples 1 to 15 were determined by atmospheric photoelectron spectroscopy. In other words, the energy (VBM) of the valence band upper edge was determined for each of the compounds of Examples 1 to 15. The measurement was performed by using a photoelectron yield spectrometer (AC-2, manufactured by RIKEN KEIKI CO., LTD.).

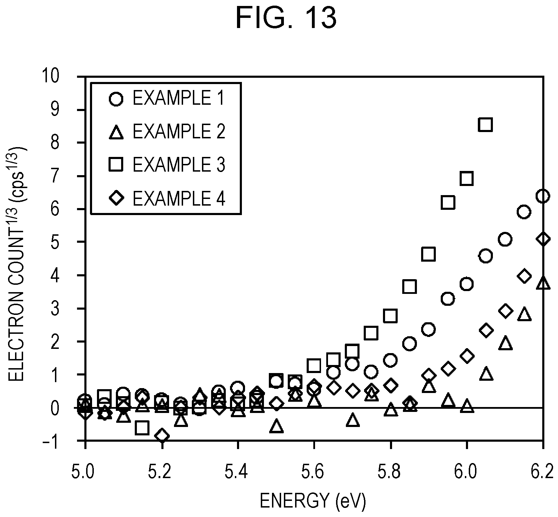

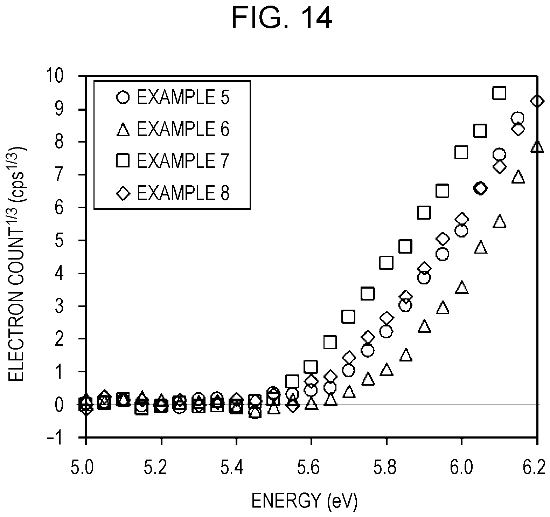

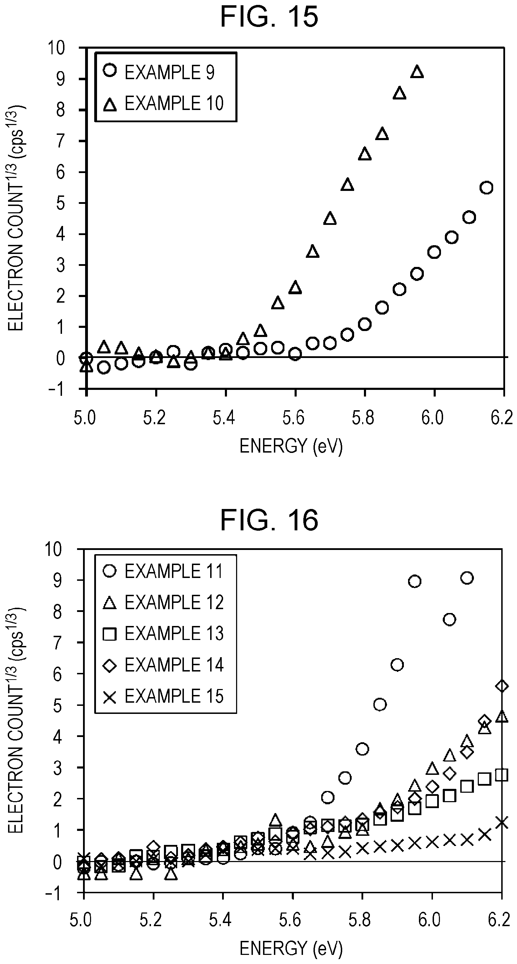

Fig. 13 is a graph illustrating photoelectron yield spectra of the compounds of Examples 1 to 4. Fig. 14 is a graph illustrating photoelectron yield spectra of the compounds of Examples 5 to 8. Fig. 15 is a graph illustrating photoelectron yield spectra of the compounds of Examples 9 and 10. Fig. 16 is a graph illustrating photoelectron yield spectra of the compounds of Examples 11 to 15. In Figs. 13 to 16, the horizontal axis indicates the light energy and the vertical axis shows the cubic root of the electron count (CPS). The work function (that is, VBM) was estimated from the intersection between the horizontal axis and point of intersection between the horizontal axis and the approximate straight line of a plot after the initial rising, that is, a plot in which the electron count was rapidly rising. Table 1 indicates VBM of Examples 1 to 15. As indicated in Table 1, the VBM of the compounds of Examples 1 to 15 were in the range of -6.00 eV to -5.19 eV.

### <Photoluminescence>

Photoluminescence measurement was carried out on the compounds of Examples 1 to 15 with a compact fluorescence lifetime spectrometer (Quantaurus-Tau produced by Hamamatsu Photonics K.K.). The excitation wavelength was 254 nm. Table 1 indicates the relative emission intensities of the compounds of Examples 1 to 15. The relative emission intensity is a value obtained by standardizing the photoluminescence of the maximum peak observed from each of the compounds of Examples 1 to 15 at a wavelength of 375 nm to 795 nm with the photoluminescence of the maximum peak observed from the compound of Example 4 at a wavelength of 375 nm to 795 nm. The photoluminescence intensity of the maximum peak observed from the compound of Example 4 at a wavelength of 375 nm to 795 nm was 541 a.u.

**[Table 1]**

| | Compound | E_{g} (eV) | VBM (eV) | Relative emission intensity |
|---|---|---|---|---|
| Example 1 | MAAgI₂ | 3.38 | -5.71 | 38.9 |
| Example 2 | FAAgI₂ | 4.05 | -6.00 | 2.5 |
| Example 3 | EAAgI₂ | 4.07 | -5.70 | 1.4 |
| Example 4 | GAAgI₂ | 3.76 | -5.92 | 1.0 |
| Example 5 | MAAg₂I₃ | 3.59 | -5.73 | 2.4 |
| Example 6 | FAAg₂I₃ | 3.68 | -5.81 | 1.5 |
| Example 7 | EAAg₂I₃ | 3.80 | -5.57 | 4.8 |
| Example 8 | GAAg₂I₃ | 3.76 | -5.66 | 7.6 |
| Example 9 | FAAgBr₂ | 4.92 | -5.75 | 11.8 |
| Example 10 | EAAgBr₂ | 4.21 | -5.45 | 3.3 |
| Example 11 | FA₂AgI₃ | 4.92 | -5.64 | 12.1 |
| Example 12 | EA₂AgI₃ | 4.11 | -5.68 | 2.4 |
| Example 13 | FA₂AgBr₃ | 4.93 | -5.32 | 11.5 |
| Example 14 | EA₂AgBr₃ | 4.90 | -5.87 | 10.3 |
| Example 15 | FA₂AgCl₃ | 4.93 | -5.19 | 10.7 |

As indicated in Table 1, the VBM of the compounds of Examples 1 to 15 were at relatively shallow positions where hole extraction is relatively easy. In addition, the bandgaps of the compounds of Examples 1 to 15 have such magnitudes that visible and infrared light is transmitted and ultraviolet light is absorbed. These results could confirm that the compounds of Examples 1 to 15 were applicable to photoelectric conversion layers of photoelectric conversion devices (for example, solar batteries and ultraviolet sensors) that operate in the ultraviolet region and emission layers of light-emitting devices such as light-emitting diodes.

Emission peaks were detected at a wavelength of 375 nm to 795 nm from all of the photoluminescence spectra of these compounds. These results could confirm that the compounds of Examples 1 to 15 had a bandgap and an energy level of the valence band upper edge that can be applied to photoelectric conversion devices that operate in the ultraviolet region, emitted light by absorbing ultraviolet light, and were applicable to light-emitting devices such as phosphors.

### <Photoelectric conversion efficiency>

The photoelectric conversion efficiencies of the photoelectric conversion devices of Example 16 and Comparative Example 1 were measured.

The photoelectric conversion efficiency was measured at the initial state and after a heat resistance test by using an electrochemical analyzer (ALS 440B produced by BAS) and a xenon light source (BPS X300BA produced by Bunkoukeiki Co., Ltd.). Before the measurement, the light intensity was calibrated to 1 Sun (100 mW/cm²) using a silicon photodiode. The voltage sweep speed was 100 mV/s. No preliminary adjustment such as light irradiation or long hours of forward bias application was conducted. In order to fix the effective area and reduce the influence of scattered light, light was irradiated from the mask/substrate side while the photoelectric conversion device was masked with a black mask having an opening of 0.1 cm². The photoelectric conversion efficiency was measured at room temperature in dry air (< 2% RH). On the basis of the aforementioned measurement, the photoelectric conversion characteristics of the photoelectric conversion device, namely, the open-circuit voltage (Voc), the short-circuit current density (Jsc), the fill factor (FF), and the photoelectric conversion efficiency (EFF), were calculated.

### <Measurement of low-light output>

The outputs of the photoelectric conversion devices of Examples 17 and 18 and Comparative Example 2 were measured.

In the measurement, an electrochemical analyzer (ALS 440B, produced by BAS) and a fluorescent lamp were used. Before the measurement, the light intensity was calibrated to 200 lux using a silicon photodiode. The voltage sweep speed was 100 mV/s. No preliminary adjustment such as light irradiation or long hours of forward bias application was conducted. In order to fix the effective area and reduce the influence of scattered light, light was irradiated from the mask/substrate side while the solar battery was masked with a black mask having an opening of 0.1 cm². The output was measured at room temperature in dry air (< 2% RH).

### <Heat resistance test A>

The photoelectric conversion devices of Example 16 and Comparative Example 1 were subjected to a heat resistance test A. In the heat resistance test A, the photoelectric conversion device was held at 85°C for 158 hours in a constant-temperature oven. After the heat resistance test A, the photoelectric conversion efficiency of the photoelectric conversion device was measured by the aforementioned method. Table 2 indicates the photoelectric conversion characteristics measured before and after the heat resistance test A.

**[Table 2]**

| | Heat resistance test | V_{OC} (mV) | J_{SC} (mA/cm²) | FF | Eff (%) |
|---|---|---|---|---|---|
| Example 16 | Before | 999 | 21.56 | 0.699 | 15.04 |
| | After | 1017 | 21.89 | 0.654 | 14.55 |
| Comparative Example 1 | Before | 1064 | 22.84 | 0.753 | 18.31 |
| | After | 1003 | 21.89 | 0.463 | 10.17 |

### <Heat resistance test B>

The photoelectric conversion devices of Examples 17 and 18 and Comparative Example 2 were subjected to a heat resistance test B. In the heat resistance test B, the photoelectric conversion device was held at 85°C for 20, 106, or 460 hours in a constant-temperature oven. After passage of each time period, the low-light output of the photoelectric conversion device was measured by the aforementioned method. The output detected when 200 lux light was radiated in the heat resistance test B is indicated in Table 3.

**[Table 3]**

| | Output (µW/cm²) | | |
|---|---|---|---|
| | 20 hours | 106 hours | 460 hours |
| Example 17 | 13.20 | 13.19 | 12.80 |
| Example 18 | 13.48 | 13.52 | 13.03 |
| Comparative Example 2 | 12.75 | 11.22 | 11.02 |

### <Effects of buffer layers on photoelectric conversion characteristics after heat resistance test>

As indicated in Table 2, the photoelectric conversion efficiency of Example 16 before the heat resistance test was lower than that of Comparative Example 1; however, the photoelectric conversion efficiency of Example 16 after the heat resistance test was higher than that of Comparative Example 1. Whereas the thermal degradation rate of the photoelectric conversion efficiency in Comparative Example 1 was -44.5%, the thermal degradation rate of the photoelectric conversion efficiency in Example 16 was -3.3%. Here, the thermal degradation rate of the photoelectric conversion efficiency was calculated by (photoelectric conversion efficiency after heat resistance test - photoelectric conversion efficiency before heat resistance test)/photoelectric conversion efficiency before heat resistance test × 100 (%). This clearly indicates that the use of EAAg₂I₃ in the buffer layer notably suppresses thermal degradation. This is presumably because the VBM of EAAg₂I₃ is positioned between the VBM of the three-dimensional perovskite constituting the photoelectric conversion layer and the HOMO level of PTAA constituting the hole transport layer, and thus the buffer layer could suppress desorption of decomposition gas (such as iodine or methylamine) from the photoelectric conversion layer generated by heat without inhibiting hole extraction. Note that the VBM of the three-dimensional perovskite that constitutes the photoelectric conversion layer in the photoelectric conversion device of Example 16 and Comparative Example 1 is -5.6 eV, the VBM of EAAg₂I₃ constituting the buffer layer is -5.57 eV, and the HOMO level of the PTAA constituting the hole transport layer is -5.3 eV.

As indicated in Table 3, the outputs of Examples 17 and 18 were both higher than that of Comparative Example 2 for all of the heat resistance test time periods. This means that defects at the interface between the photoelectric conversion layer and the hole transport layer decreased. In Examples 17 and 18, the decrease in output caused by passage of time was notably suppressed compared to Comparative Example 2. This clearly indicates that the use of FAAgBr₂ or EAAgBr₂ in the buffer layer also notably suppresses thermal degradation. This is presumably because the buffer layer could suppress desorption of decomposition gas (such as iodine or methylamine) from the photoelectric conversion layer generated by heat. Note that the VBM of the three-dimensional perovskite that constitutes the photoelectric conversion layer in the photoelectric conversion device of Examples 17 and 18 and Comparative Example 2 is -5.66 eV, the VBM of FAAgBr₂ constituting the buffer layer is -5.75 eV, the VBM of EAAgBr₂ is -5.45 eV, and the HOMO level of the PTAA constituting the hole transport layer is -5.3 eV. The factor behind Example 18 giving higher output than Example 17 is that the VBM of EAAgBr₂ is positioned between the VBM of the three-dimensional perovskite constituting the photoelectric conversion layer and the HOMO level of PTAA constituting the hole transport layer, and hole extraction was not inhibited.

These results could confirm that, by using the compound of the present disclosure in a buffer layer disposed between the photoelectric conversion layer and the hole transport layer, the heat resistance of the photoelectric conversion device is prominently improved.

### Industrial Applicability

Since the compound of the present disclosure has a large bandgap and has a valence band upper edge with a shallow energy level, the compound is applicable to electronic devices such as photoelectric conversion devices (see-through solar batteries, ultraviolet sensors, etc.) in the ultraviolet region and light-emitting devices and thus has particularly high industrial applicability.

### Reference Signs List

1 substrate
2 first electrode
3 electron transport layer
4 photoelectric conversion layer
5 hole transport layer
6 second electrode
7 porous layer
8 intermediate layer
9 buffer layer
100, 200, 300, 400 solar battery

## Claims

1. A compound consisting of:
A, Ag, and X,
where A is a monovalent cation and comprises an organic cation, and
X is at least one selected from the group consisting of a halide ion and a thiocyanate ion.

2. The compound according to claim 1,
wherein the compound has a bandgap greater than or equal to 3.10 eV and less than or equal to 5.10 eV.

3. The compound according to claim 1 or 2, wherein the compound has a valence band upper edge having an energy level greater than or equal to -6.20 eV and less than or equal to -5.00 eV with respect to a vacuum level.

4. The compound according to any one of claims 1 to 3,
wherein the organic cation has an ionic radius greater than or equal to 216 pm and less than or equal to 450 pm.

5. The compound according to any one of claims 1 to 4,
wherein the organic cation is at least one selected from the group consisting of a hydroxylamine cation, a methylammonium cation, a hydrazinium cation, an azetidinium cation, a formamidinium cation, an imidazolium cation, a dimethylammonium cation, an ethylammonium cation, a guanidinium cation, a trimethylammonium cation, a tetramethylammonium cation, a thiazolium cation, a piperazinium cation, a tropylium cation, a dabconium cation, a butylammonium cation, a benzylammonium cation, a phenethylammonium cation, and a tetrapropylammonium cation.

6. The compound according to claim 5, wherein the organic cation is at least one selected from the group consisting of a methylammonium cation, a formamidinium cation, an ethylammonium cation, and a guanidinium cation.

7. The compound according to any one of claims 1 to 6,
wherein the compound is represented by AAgX₂, AAg₂X₃, or A₂AgX₃.

8. The compound according to any one of claims 1 to 7,
wherein X comprises an iodide ion.

9. An electronic device comprising a first electrode, a photoelectric conversion layer, and a second electrode arranged in this order,
wherein the electronic device comprises
the compound according to any one of claims 1 to 8.

10. The electronic device according to claim 9, wherein the photoelectric conversion layer comprises the compound.

11. The electronic device according to claim 9, further comprising:
a hole transport layer and a buffer layer,
wherein the hole transport layer is disposed between the photoelectric conversion layer and the second electrode,
the buffer layer is disposed between the hole transport layer and the photoelectric conversion layer, and
the buffer layer comprises the compound.

12. A light-emitting device comprising:
an emission layer,
wherein the emission layer comprises the compound according to any one of claims 1 to 8.
